(19) Europäisches Patentamt
European Patent Office
Office européen des brevets

(11) **EP 3 640 658 B1**

(12) **EUROPEAN PATENT SPECIFICATION**

(45) Date of publication and mention
of the grant of the patent:
**09.08.2023 Bulletin 2023/32**

(21) Application number: **18818060.8**

(22) Date of filing: **18.05.2018**

(51) International Patent Classification (IPC):
*G01R 33/02* (2006.01)    *H10N 50/00* (2023.01)
*G01R 33/00* (2006.01)    *G01R 33/06* (2006.01)

(52) Cooperative Patent Classification (CPC):
**G01R 33/0023; G01R 33/02; H01L 29/82;
H10N 50/00;** G01R 33/063

(86) International application number:
**PCT/JP2018/019392**

(87) International publication number:
**WO 2018/230262 (20.12.2018 Gazette 2018/51)**

(54) **ULTRA HIGH-SENSITIVITY MICRO MAGNETIC SENSOR**

MIKROMAGNETSENSOR MIT ULTRAHOHER EMPFINDLICHKEIT

CAPTEUR MICROMAGNÉTIQUE À TRÈS HAUTE SENSIBILITÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.06.2017 JP 2017119171**

(43) Date of publication of application:
**22.04.2020 Bulletin 2020/17**

(73) Proprietor: **Asahi Intecc Co., Ltd.**
**Seto-shi, Aichi 489-0071 (JP)**

(72) Inventors:
• **HONKURA Yoshinobu**
**Aichi 470-2102 (JP)**
• **HONKURA Shinpei**
**Aichi 470-2102 (JP)**

(74) Representative: **Winter, Brandl - Partnerschaft
mbB**
**Alois-Steinecker-Straße 22
85354 Freising (DE)**

(56) References cited:
EP-A1- 2 199 814          WO-A1-2009/044820
WO-A1-2010/102376    WO-A1-2014/115765
WO-A1-2015/060344    WO-A1-2017/061513
WO-A1-2017/213003    JP-A- 2006 300 906
JP-A- 2016 003 866     JP-B1- 5 839 527
US-A1- 2011 080 164    US-A1- 2016 238 673

**Description**

Field

The present invention relates to a technology of improving sensitivity characteristics of a GSR sensor by adopting rising pulse detection.

Here, the GSR sensor is a ultra high-sensitivity micro magnetic sensor based on the GHz spin rotation effect.

Background

The high-sensitivity micro magnetic sensor includes a horizontal FG sensor, a vertical FG sensor, a hole sensor, a GMR sensor, a TMR sensor, a MI sensor, a GSR sensor, a high frequency carrier sensor, and the like. These sensors are currently used widely in smartphones, vehicles, medical treatment, robots, and the like. Among the above-described sensors, the GSR sensor is excellent in sensitivity and size, and draws the most attention.

To achieve remote control of an in-vivo motion device, an investigation is currently advanced for finding a position and a direction by providing a three-dimensional magnetic sensor utilizing a GSR sensor.

In this regard, US 2016/0238673 A1 relates to a GSR sensor based on spin rotation effect with ultra-high speed powered by GHz pulse current.

The sensor is preferably smaller to provide it in a motion device. However, the detection sensitivity is deteriorated inversely proportional thereto. Furthermore, with the restriction of a supply power source, the reduction of power consumption during measurement has been demanded.

Citation List

Patent Literature

Patent Literature 1: Japanese Patent No. 5839527
Patent Literature 2: US 2016/0238673 A1

Summary

Technical Problem

As the detection method by the GSR sensor, there exist two methods of rising pulse detection and falling pulse detection. In rising pulse detection, the magnetic field sensitivity is about 2.5 times as high as that of falling pulse detection, which shortens pulse time and reduces power consumption. However, the linearity is about 1 to 2% and is inferior to that of falling pulse detection of 0.5% or lower.

The invention aims at making the most use of advantages of rising pulse detection while making its linearity 0.5% or lower.

A coil output voltage (hereinafter, referred to as a coil voltage) of the GSR sensor includes two kinds of voltages of an induced voltage dependent on a pulse current (referred to as an "a voltage") and a voltage dependent on an external magnetic field (referred to as a "b voltage"). In comparison between rising pulse detection and falling pulse detection, two voltage peaks are more adjacent to each other in the case of falling pulse detection, and the influence by a pulse current is larger. Moreover, the MI effect changes the impedance of magnetic wires by a magnetic field. As a result, the "a voltage" dependent on a pulse current is also influenced by the magnetic field, and may not be canceled easily. That is, if the "a voltage" is not influenced by a magnetic field, the "a voltage" may be measured with H = 0G, and a net b voltage may be thus detected by cancelling the "a voltage".

The investigation for removing an induced voltage dependent on a pulse current from a coil voltage found by rising pulse detection has been performed for 20 years. However, it remains an unsolved difficult problem. Solution to Problem

This object is solved by the subject matter of the independent claim, which has been drafted starting form US 2016/0238673 A1. Further aspects are disclosed in the subclaims.

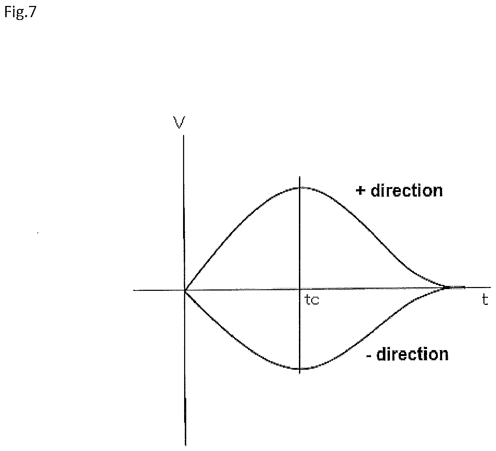

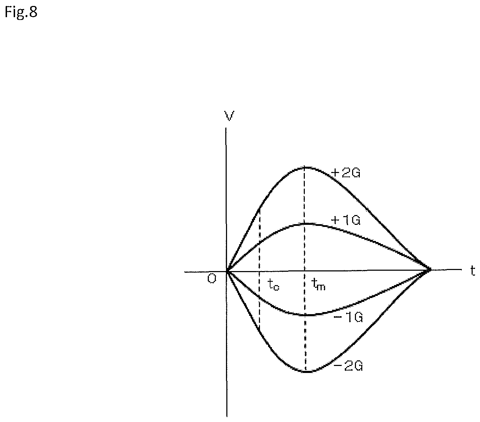

The inventors found that if two magnetic wires are arranged in one coil and a pulse current is applied in opposite directions, a coil induced voltage of rising pulse detection becomes 0 when H = 0 G (Fig. 7). It is recognized that if an electric current is applied in opposite directions in the case where a magnetic field H exists, the coil voltage is not changed and only the "b voltage" is detected (Fig. 8). That is, the "a voltage" is apparently disappeared.

Furthermore, in the measurement of the "b voltage" while changing a magnetic field, they found that the voltage is linearly output symmetrically relative to the positive/negative of the magnetic field with the linearity of 0.3% or lower, which is excellent.

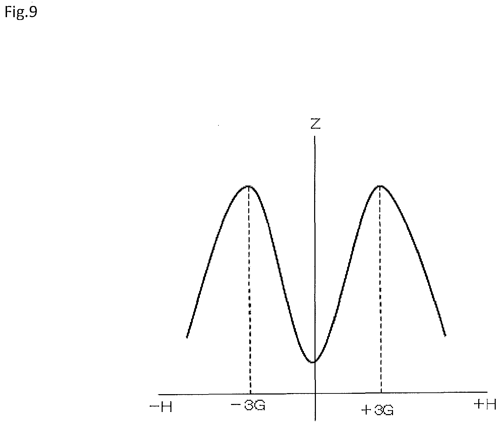

Even when the magnetic field H is changed from zero, the "a voltage" is disappeared. This is apparently because the impedance of two wires is changed symmetrically relative to the magnetic field H, regardless of a direction of an electric current, and thus the impedance thereof is constantly same and a pulse current flowing in the two wires is same, which cancels the influence on their coils even when a magnetic field is changed (Fig. 9).

In the case of rising pulse detection, the detection is performed with rising, which allows pulse time of 1 ns (1 nanosecond) or shorter. Meanwhile, in the case of falling pulse detection, the detection needs to be performed after the rising coil voltage is attenuated completely. Thus, the pulse time needs to be maintained for about 10 ns. Therefore, if the rising pulse detection is adopted, the pulse current consumption may be 1/10 or smaller.

The coil voltage of the element including two magnetic wires of the invention is twice the coil voltage of the element including one magnetic wire. Moreover, the coil voltage in rising pulse detection is 2.5 times the coil voltage in falling pulse detection (Fig. 10). As compared with the GSR sensor described in Patent Literature 1, the coil voltage is five times with the element of the same size.

It is confirmed that the relation between the coil voltage and the external magnetic field is same as the equation in the GSR sensor described in Patent Literature 1. That is,

$$Vs = Vo \cdot 2L \cdot \pi D \cdot p \cdot Nc \cdot f \cdot \sin(\pi H/2Hm) \ \text{......} \ (1)$$

Here, Vs is a coil voltage, and Vo is a constant of proportionality determined by wire magnetic permeability, magnetic characteristics of wire materials with saturation magnetic flux density, and a pulse current. As a control factor constant, L is a wire length, D is a wire diameter, p is a skin depth of a pulse current, Nc is the number of winding of a coil, f is a pulse frequency, H is an external magnetic field, Hm is an external magnetic strength to obtain the maximum coil output voltage.

By applying arcsine transformation to both sides of the equation (1) and letting the resulted value to be a conversion voltage V', the following equations (2) and (3) are obtained:

$$V' = \arcsin(Vs/Vo \cdot 2L \cdot \pi D \cdot p \cdot Nc \cdot f) = (\pi \cdot 1/2Hm) \ \cdot H \ \text{......} \ (2)$$

$$H = 2Hm/\pi \times V' \ \text{......} \ (3)$$

H is found on the basis of the expression (3).

V' is changed linearly from -Hm to +Hm relative to the magnetic field H. The measurement range is Hm, and is about four times that in the case without arcsine transformation. Note that when Vx = a(1-Δ)Hx, the linearity P is defined as P = 100×Δ (%).

That is, the linearity is defined on the basis of a deviation amount Δ from the equation Vx = aHx when Δ = 0.

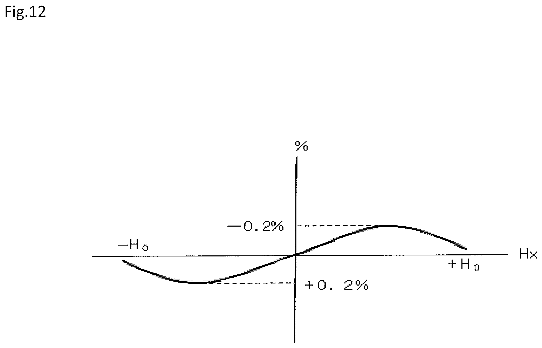

Furthermore, it is confirmed that the linearity is 0.2%, which is more preferable than 0.5% that is a deviation amount of a falling pulse of the GSR sensor (Fig. 12) .

The GSR sensor strengthens electromagnetic coupling between the magnetic wire and the coil with the interval between the magnetic wire and the coil inner diameter of 3 um or smaller. Also in the invention, the same relation remains except for the interval between the two magnetic wires.

The same electronic circuit as in Patent Literature 1 is adopted. The pulse frequency of a pulse current applied to the magnetic wire is 0.2 GHz to 4 GHz. The pulse current has the strength required to generate on the surface of a magnetic wire over a 1.5 times larger circumferential magnetic field than the magnetic anisotropy field.

The coil voltage occurring at the time of pulse energization is fed to a sample hold circuit through a pulse compliant buffer circuit. With the small number of winding of the coil, the coil voltage may be fed directly to the sample hold circuit.

The rising pulse is detected using an electronic switch at the peak timing of a coil output waveform. The "a voltage" does not exist, and thus the temporal timing of the peak voltage is constant without being dependent on the magnetic field H. However, if the "a voltage" exists, the peak timing is changed depending on the magnetic field H. Thus, strictly speaking, it is not possible to adjust the detection at the peak timing of a coil output waveform. This causes nonlinearity.

The capacitor capacitance of the sample hold circuit is 4 pF to 100 pF. it is preferable that the intervals between on and off of the electronic switch is shortened as much as possible to also reduce the capacitor capacitance to 4 pH to 8pH. In this manner, the voltage at the peak timing is held by the capacitor as an instantaneous voltage value. The held capacitor voltage is output through a programming amplifier.

Advantageous Effects of Invention

The rising pulse detection type GSR sensor achieves, with the same element size, five times magnetic field detection sensitivity and 1/10 or less power consumption, enabling considerable downsizing of the magnetic sensor with an in-vivo motion device.

Brief Description of Drawings

Fig. 1 is a plane view of a GSR sensor element according to an embodiment and an example,
Fig. 2 is a section view of the GSR sensor element along line A1-A2 of Fig. 1,
Fig. 3 is an electronic circuit diagram according to the embodiment and the example,
Fig. 4 is a relational diagram between the pulse time and the pulse current application according to the embodiment and the example,
Fig. 5 is a waveform chart of a coil voltage when a pulse current is applied according to the embodiment and the example,
Fig. 6 is an output waveform chart according to the embodiment and the example,
Fig. 7 is a diagram of an output V when two magnetic wires are subjected to a pulse current in opposite directions (+ direction and - direction) when the external magnetic field H = 0,
Fig. 8 is a diagram of an output V when the external magnetic field H = -2G to +2G,
Fig. 9 is a relational diagram between the external magnetic field H and impedance Z,

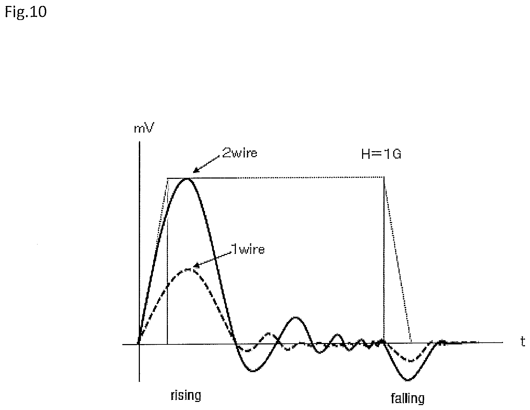

Fig. 10 is an output diagram of the coil voltage in rising pulse detection and falling pulse detection with one magnetic wire and two magnetic wires,

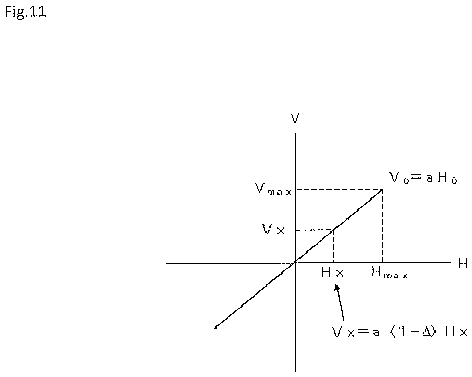

Fig. 11 is an explanatory diagram of the linearity P in relation between the change of the external magnetic field and the output, and
Fig. 12 is a relational diagram between the magnetic field Hx and a deviation amount in the rising pulse of the GSR sensor.

Description of Embodiments

An embodiment of the invention is described as follows.
Note that one, or two or more configurations arbitrarily selected from the specification may be added to the configuration of the invention. The most preferable embodiment varies depending on a subject and required characteristics.
A GSR sensor that is a ultra high-sensitivity micro magnetic sensor according to the invention includes

a magnetic field detection element including two conductive magnetic wires for magnetic field detection arranged adjacent to each other on a substrate, a round coil wound around the two magnetic wires, two electrodes for wire energization, and two electrodes for coil voltage detection, a means for applying a pulse current to the magnetic wires, a circuit for detecting a coil voltage occurred when the pulse current is applied to the magnetic wires in opposite directions, and a means for converting the coil voltage into an external magnetic field H,
in which the magnetic wire has a magnetic anisotropy field of 20 G or less, with a two-phase magnetic domain structure of a surface magnetic domain with circumferential spin alignment and a center core magnetic domain with longitudinal spin alignment, and
the pulse current applied to the magnetic wire has a pulse frequency of 0.2 GHz to 4 GHz and a strength required to generate over a 1.5 times larger circumferential magnetic field than the anisotropy field on a surface of the wire, and the coil has a coil pitch of 10 um or less. The average inner diameter of the coil is preferably 35 um or smaller.

In the case where a plurality of pairs of wires are arranged, the interval between the coil and the magnetic wire is preferably 1 um to 5 um.
Moreover, in the GSR sensor that is the ultra high-sensitivity micro magnetic sensor according to the invention, the pulse current is applied to the magnetic wire, and the circumferential spin inclined in an axial direction is subjected to super high speed rotation by a wire axial magnetic field in the surface magnetic domain, to take out only a magnetization change in the wire axial direction due to a super high speed rotation phenomena occurred at the rotation and perform conversion into a field H using an equation (1):

$$Vs = Vo \cdot 2L \cdot \pi D \cdot p \cdot Nc \cdot f \cdot \sin(\pi H / 2Hm) \quad \text{...... (1)}$$

where Vs is a coil output voltage and Vo is a constant of proportionality, and as a control factor constant, L is a wire length, D is a wire diameter, p is a skin depth of a pulse current, Nc is the number of winding of a coil, f is a pulse frequency, Hm is an external magnetic strength to obtain a maximum coil output voltage.

Furthermore, the GSR sensor that is the ultra high-sensitivity micro magnetic sensor according to the invention further includes an electronic circuit including a pulse generating circuit for generating the pulse current, an input circuit for inputting a coil voltage, a pulse compliant buffer circuit, a sample hold circuit with an electronic switch for detecting a peak voltage of an output waveform of the coil voltage and a capacitor with a capacitance of 4 to 100 pF for holding the peak voltage, and an programming amplifier for amplification before AD (analog-digital) conversion.

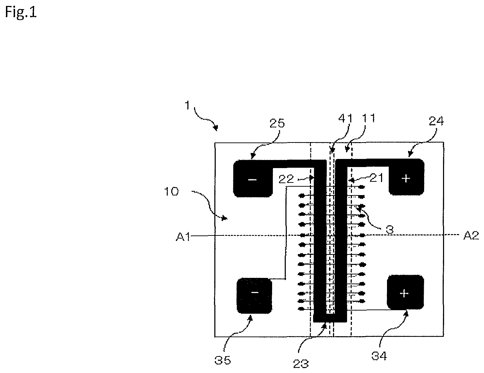

The embodiment of the invention will be described in detail with reference to Fig. 1 to Fig. 6.

The GSR sensor element (hereinafter, referred to as an element) 1 includes, on a substrate 10, two magnetic wires (21 and 22), one coil 3 wound around the two magnetic wires, two electrodes (24 and 25) for wire energization, two electrodes (34 and 35) for coil voltage detection, a connection part between the magnetic wires and the wire energization electrodes, and a connection part between the coil and the coil voltage detection electrodes. Moreover, the element 1 includes a means 23 for applying a pulse current to the two magnetic wires (21 and 22) in opposite directions. Then, the element 1 further includes a circuit 5 for detecting a coil voltage occurred when a pulse current is applied and a means for converting a coil voltage into an external magnetic field. The external magnetic field H and the coil voltage Vs are expressed by the mathematical relation of the above-described expression (1) .

< Structure of element >

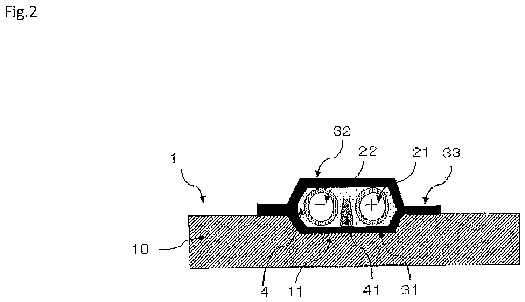

The structure of the element 1 is as illustrated in Fig. 1 and Fig. 2.

The size of the element 1 is 0.07 mm to 0.4 mm in width and 0.25 mm to 1 mm in length, which is the size of the substrate 1. In the center part of the element 1, the substrate 10 has a groove of 20 to 60 um in width and 2 to 20 um in depth so that the two magnetic wires (21 and 22) are aligned and disposed in parallel to each other. The two magnetic wires (21 and 22) are adjacent to each other with the interval of 1 to 5 um. The magnetic wires (21 and 22) are isolated from each other by an insulating separation wall.

< Magnetic wire >

The magnetic wire 2 is formed of a CoFeSiB amorphous alloy with a diameter of 5 to 20 um. The periphery of the magnetic wire 2 is preferably coated with an insulating material, such as insulating glass, for example. The length is 0.07 to 1.0 mm.

The magnetic wire 2 has a magnetic anisotropy field of 20 G or less, with a two-phase magnetic domain structure of a surface magnetic domain with circumferential spin alignment and a center part core magnetic domain with axial spin alignment.

< Coil >

In the coil 3, it is preferable that the number of winding of the coil is 6 to 180 times and the coil pitch is 5 um. The interval between the coil 3 and the magnetic wire 2 is preferably 3 um or smaller. The average inner diameter of the coil is preferably 10 to 35 um.

< Manufacturing method of element >

The manufacturing method of the element is described with reference to Fig. 2.

Electrode wiring is performed on a lower coil 31 and the substrate surface along the groove 11 formed on the substrate 10. Then, an insulating separation wall 41 is formed in the center part of the groove 11 to have a two-groove form, and each of the two magnetic wires 21 and 22 coated with glass is arranged therein. Next, an insulating resist is applied to the entire surface of the substrate. Thus, the magnetic wires 21 and 22 are fixed in the groove 11. The insulating resist is applied thinly onto the upper part of the magnetic wires 21 and 22. At that part, an upper coil 32 is formed by a photolithographic technology.

In the case where the magnetic wires 2 not coated with glass are used, an insulating material 4 needs to be preliminarily applied to prevent electrical contact between the lower coil 31 and the magnetic wires 21 and 22.

In the manufacturing of the coil, the recessed lower coil 31 is formed along the groove surface and the both sides of the groove 11 formed on the substrate 11. The projecting upper coil 32 is electrically jointed to the lower coil through a joint part 33 to form the spiral coil 3.

At the ends of the two magnetic wires 21 and 22, glass as an insulating film is removed to allow electrical connection by metal vapor deposition.

< Magnetic wire and coil wiring structure >

In the wiring structure of the magnetic wire 2, the wire input electrode (+) 24 is connected to the upper part of the magnetic wire 21, and the lower part of the magnetic wire 21 is connected to the lower part of the magnetic wire 22 through the wire connection part 23, as illustrated in Fig. 1. The upper part of the magnetic wire 22 is connected to the wire output electrode (-) 25. This wire connection part 23 enables a downward flow of a pulse current from the upper part to the lower part in the magnetic wire 21, and an upward flow of a pulse current from the lower part to the upper part (in the opposite direction from the direction in the magnetic wire 21) in the magnetic wire 22.

In the wiring structure of the coil 3, the coil output electrode (+) 34 is connected to the lower end part of the coil 3, and the upper end part of the coil 3 is connected to a coil ground electrode (-) 35, as illustrated in Fig. 1.

< Electronic circuit >

An electronic circuit 5 includes a pulse generating circuit 51 for generating a pulse current, an input circuit 53 for inputting a coil voltage, a pulse compliant buffer circuit 54, the sample hold circuit with an electronic switch 56 for detecting a peak voltage of an output waveform of a coil voltage and a capacitor with a capacitance of 4 to 100 pF for holding a peak voltage, and an amplifier 58. The amplifier 58 includes a programming amplifier for amplification before AD conversion.

Moreover, the GSR sensor element is connected to output a coil voltage of the electronic circuit 5.

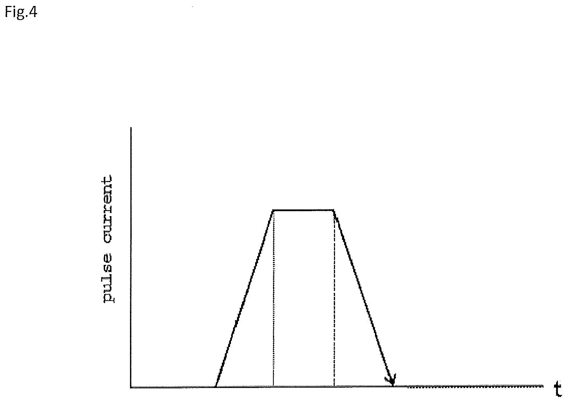

At a pulse frequency of a pulse current of 0.2 to 4 GHz, the pulse current strength is 50 to 200 mA and the pulse time is 0 to 2 nsec. Fig. 4 illustrates the relation between the elapse of energizing time and the application of a pulse current when the pulse current is applied to the GSR sensor element. In the example of Fig. 4, the pulse current rises in 0.5 nsec from the start of energization, and this applied state is kept for given pulse time of 0.5 nsec. Once such energization is cut off, the pulse current falls in 0.5 nsec.

< Waveform of coil voltage >

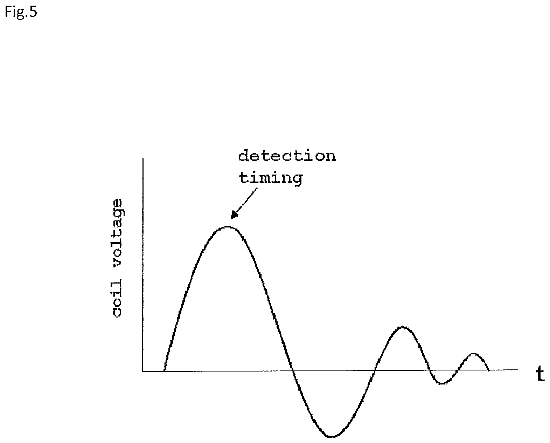

Fig. 5 illustrates a waveform chart of a coil voltage when the above-described pulse current is applied.

In the invention, the timing of a peak voltage is detected. The electronic switch is turned on and off repeatedly with the opening-closing time of 0.1 to 1.5 nsec.

The capacitor capacitance of the sample hold circuit is 4 to 100 pF, and the AD conversion of the electronic circuit is 14 to 16 bits. Note that to shorten the interval of the on and off of the electronical switch, the capacitor capacitance is preferably 4 to 8 pF.

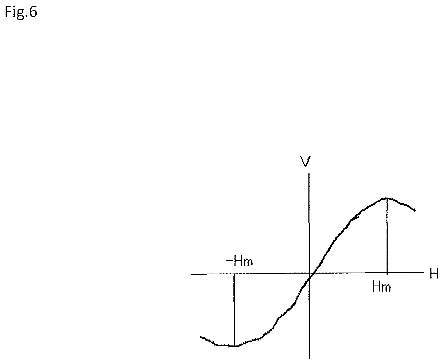

In the coil output, the sensitivity is 50 mV/G to 3 V/G in the measurement range of 3 to 100G with a sin wave output, as illustrated in Fig. 6. The linearity is 0.3% or lower.

< Example >

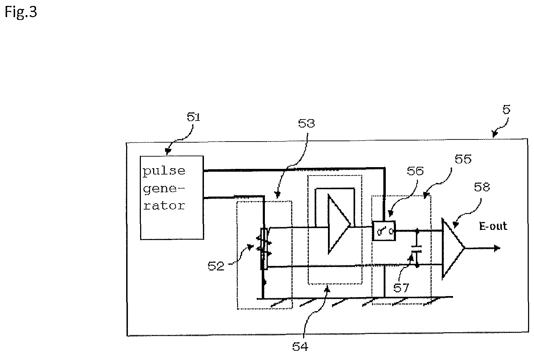

Fig. 1 illustrates a plane view of the GSR sensor element according to the example. Fig. 2 illustrates a section view thereof. Fig. 3 illustrates an electronic circuit. The GSR sensor of the invention includes the GSR sensor element 1 having the two magnetic wires (21 and 22), the one coil 3 wound around the two magnetic wires, the two electrodes (24 and 25) for wire energization, and the electrodes (34 and 35) for coil voltage detection, the means for applying a pulse current to the magnetic wire 2, the circuit for detecting a coil voltage occurred when the pulse current is applied, and the means for converting a coil voltage into an external magnetic field H. The external magnetic field H and the coil voltage are expressed in the mathematical relation shown in the expression (1).

The size of the element 1 is 0.12 mm in length and 0.20 mm in width. The groove 11 on the substrate 10 is 40 um in width and 8 um in depth. The wire interval is 3 um.

The magnetic wire (21 and 22) is formed of a CoFeSiB amorphous alloy coated with glass of 10 um in diameter and 1 um or smaller in thickness.

The magnetic anisotropy field is 15G.

In the coil 3, the number of winding is 14 times with a coil pitch of 5 um. The average inner diameter of the coil 3 is 30 um, and the interval between the coil 3 and the magnetic wire 2 is 2 um.

In the structure of the element, the half in diameter of the magnetic wires (21 and 22) coated with glass is embedded in the groove 11 formed on the substrate 10. The lower coil 31 is arranged on the inner surface of the groove 11, and the upper coil 32 is arranged above the magnetic wires. The lower coil 31 and the upper coil 32 are fixed with insulating resin and jointed by the joint part 33 on the substrate surface.

Between each of both end parts of the coil 3 and each of the coil electrodes, electrical connection part is provided using a conductive metal vapor deposition film.

In the magnetic wires 2 and the electrodes, after removing the glass coating material on the upper surface part at the end part of the magnetic wires, an electrical joint part is provided using a conductive metal vapor deposition film between the wire surface with the coating removed and the electrode.

Moreover, the connection part 23 between the two magnetic wires 21 and 22 is also subjected to electrical connection by the same processing.

The GSR sensor element 1 is provided in the electronic circuit 5 and is energized by the pulse generation circuit 51 with a pulse width of 0.8 nnsec at a pulse frequency of 1 GHz and a pulse current strength of 120 mA. The interval of the on and off of the electronic switch is 0. 2 nsec. The capacitor capacitance of the sample hold circuit is 6pF.

16 bits are obtained by AD conversion. Moreover, with the sine wave output, the sensitivity is 200 mV in the measurement range of 90G. At the time, the power consumption is 0.3 mW, and the linearity is 0.2%.


Industrial Applicability

The invention achieves higher sensitivity and lower power consumption of the GSR sensor. The invention is expected to be used when ultra small size and high performance are required such as in the in-vivo motion device.


Reference Signs List

1    GSR sensor element
10   substrate
11   groove
2    magnetic wire
21   one of two magnetic wires
22   the other of two magnetic wires
23   wire connection part
24   wire input electrode (+)
25   wire output electrode (-)
3    coil
31   lower coil
32   upper coil
33   joint part
34   coil output electrode (+)
35   coil ground electrode (-)
4    insulating resin
41   insulating separation wall
5    electronic circuit
51   pulse generation circuit
52   GSR sensor element
53   input circuit
54   buffer circuit
55   sample hold circuit
56   electronic switch
57   capacitor
58   amplifier


**Claims**

1.  A micro magnetic sensor, comprising:

    a magnetic field detection element (1) including
    a substrate (10) having a groove (11),
    two conductive magnetic wires (21, 22) for magnetic field detection arranged adjacent and parallel to each other on the substrate (10) and fixed in the groove (11), the lower ends of the two magnetic wires (21, 22) are connected through a wire connection part (23),
    two electrodes (24, 25) for wire energization,

a connection part between the magnetic wires (21, 22) and the two electrodes (24, 25) for wire energization,
a round coil (3) wound around the two magnetic wires (21, 22),
two electrodes (34, 35) for coil voltage detection, and
a connection part between the coil (3) and the two electrodes (34, 35) for coil voltage detection;
a pulse current applying circuit (51) configured to apply a pulse current to the magnetic wires (21,22);
a coil voltage detecting circuit (54) configured to detect a coil voltage occurred when the pulse current is applied to the two magnetic wires (21,22); and
a voltage converting circuit (55 and 58) configured to convert the coil voltage into an external magnetic field H, wherein

the two conductive magnetic wires (21, 22) have a magnetic anisotropy field of 20 G or less, with a two-phase magnetic domain structure of a surface magnetic domain with circumferential spin alignment and a center core magnetic domain with longitudinal spin alignment, and
the pulse current applied to the magnetic wires (21, 22) has a pulse frequency of 0.2 GHz to 4.0 GHz and a strength required to generate an over 1.5 times larger circumferential magnetic field than the anisotropy field on a surface of the wire, and
the coil (3) has a coil pitch of 10 μm or less, **characterized in that**, in the magnetic field detection element (1), the two conductive magnetic wires (21, 22) are arranged over a lower part (31) of the coil (3), and are fixed and covered by an insulating resin,
an upper part (32) of the coil (3) is provided on the insulating resin,
the one round coil (3) is wound around the two magnetic wires (21, 22), and
an insulating separation wall (41) is arranged between the two magnetic wires (21, 22).

2. The magnetic sensor of claim 1, wherein the voltage converting circuit (55 and 58) is configured to convert the coil voltage into the external magnetic field H using an equation:

$$Vs = Vo \cdot 2L \cdot \pi D \cdot p \cdot Nc \cdot f \cdot \sin(\pi H/2Hm) \quad \ldots\ldots \quad (1)$$

where Vs is a coil output voltage and Vo is a constant of proportionality, and as a control factor constant, L is a wire length, D is a wire diameter, p is a skin depth of a pulse current, Nc is number of winding of a coil, f is a pulse frequency, Hm is an external magnetic strength to obtain a maximum coil output voltage.

3. The magnetic sensor of claim 1, wherein the pulse current applying circuit (51) comprises a pulse generating circuit configured to generate the pulse current, and the coil voltage detecting circuit (54) comprises an input circuit, a pulse compliant buffer circuit configured to input the coil voltage, a sample hold circuit with an electronic switch configured to detect a peak voltage of an output waveform of the coil voltage, a capacitor with a capacitance of 4 to 100 pF configured to hold the peak voltage, and a programming amplifier configured to perform amplification before analog-digital conversion.

4. The magnetic sensor according to claims 1 to 3, wherein the two conductive magnetic wires (21, 22) are formed of a CoFeSiB amorphous alloy with a diameter in the range of about 5 um to about 20 um and the length of each of the two conductive magnetic wires is in the range from about 0.07 mm to about 1.0 mm.

5. The magnetic sensor according to claims 1 to 4, wherein the number of windings of the coil (3) is in the range from 6 to 180.

6. The magnetic sensor according to claims 1 to 5, wherein the space between the coil (3) and the two conductive magnetic wires (21, 22) is 3μm of less.

**Patentansprüche**

1. Mikromagnetischer Sensor mit

einem Magnetfelddetektionselement (1) mit

einem Substrat (10) mit einer Rille (11),

zwei leitenden Magnetdrähten (21, 22) zur Magnetfelddetektion, die nebeneinander und parallel zueinander auf dem Substrat (10) angeordnet und in der Rille (11) befestigt sind,

wobei die unteren Enden der zwei Magnetdrähte (21, 22) durch ein Drahtverbindungsteil (23) verbunden sind,

zwei Elektroden (24, 25) zur Drahtenergiespeisung,

einem Verbindungsteil zwischen den Magnetdrähten (21, 22) und den zwei Elektroden (24, 25) zur Drahtenergiespeisung,

einer runden Spule (3), die um die zwei Magnetdrähte (21, 22) gewickelt ist,

zwei Elektroden (34, 35) zur Erfassung der Spulenspannung, und

einem Verbindungsteil zwischen der Spule (3) und den zwei Elektroden (34, 35) zur Erfassung der Spulenspannung;

einer Pulsstrom-Anlegeschaltung (51), die konfiguriert ist, um einen Pulsstrom an die Magnetdrähte (21, 22) anzulegen;

einer Spulenspannungserfassungsschaltung (54), die konfiguriert ist, um eine Spulenspannung zu erfassen, die auftritt, wenn der Pulsstrom an die zwei Magnetdrähte (21, 22) angelegt wird; und

einer Spannungsumwandlungsschaltung (55 und 58), die konfiguriert ist, um die Spulenspannung in ein externes Magnetfeld H umzuwandeln, wobei

die zwei leitenden Magnetdrähte (21, 22) ein magnetisches Anisotropiefeld von 20 G oder weniger aufweisen, mit einer zweiphasigen magnetischen Domänenstruktur aus einer Oberflächenmagnetdomäne mit Umfangsspinausrichtung und einer zentralen Kernmagnetdomäne mit Längsspinausrichtung, und

der an die Magnetdrähte (21, 22) angelegte Pulsstrom eine Pulsfrequenz von 0,2 GHz bis 4,0 GHz und eine Stärke aufweist, die erforderlich ist, um ein mehr als 1,5-mal größeres Umfangsmagnetfeld als das Anisotropiefeld an einer Oberfläche des Drahtes zu erzeugen, und

die Spule (3) eine Spulenteilung von 10 $\mu$m oder weniger aufweist, **dadurch gekennzeichnet, dass** in dem Magnetfelddetektionselement (1)

die zwei leitenden Magnetdrähte (21, 22) über einem unteren Teil (31) der Spule (3) angeordnet sind und mit einem isolierenden Harz befestigt und bedeckt sind,

ein oberer Teil (32) der Spule (3) auf dem isolierenden Harz vorgesehen ist,

die eine runde Spule (3) um die zwei Magnetdrähte (21, 22) gewickelt ist, und

eine isolierende Trennwand (41) zwischen den zwei Magnetdrähten (21, 22) angeordnet ist.

2. Magnetsensor nach Anspruch 1, wobei die Spannungsumwandlungsschaltung (55 und 58) konfiguriert ist, um die Spulenspannung in das externe Magnetfeld H unter Verwendung einer Gleichung

$$Vs = Vo \cdot 2L \cdot \pi D \cdot p \cdot Nc \cdot f \cdot \sin(\pi H/2Hm) \quad ...... \quad (1)$$

umzuwandeln,

wobei Vs eine Spulenausgangsspannung und Vo eine Proportionalitätskonstante ist, und als eine Steuerfaktorkonstante L eine Drahtlänge ist, D ein Drahtdurchmesser ist, p eine Eindringtiefe eines Pulsstroms ist, Nc die Anzahl der Windungen einer Spule ist, f eine Pulsfrequenz ist, Hm eine externe Magnetstärke ist, um eine maximale Spulenausgangsspannung zu erhalten.

3. Magnetsensor nach Anspruch 1, wobei die Pulsstrom-Anlegeschaltung (51) eine Pulserzeugungsschaltung umfasst, die konfiguriert ist, um den Pulsstrom zu erzeugen, und die Spulenspannungserfassungsschaltung (54) eine Eingangsschaltung, eine pulskonforme Pufferschaltung, die konfiguriert ist, um die Spulenspannung einzugeben, eine Abtast-Halte-Schaltung mit einem elektronischen Schalter, die konfiguriert ist, um eine Spitzenspannung einer Ausgangswellenform der Spulenspannung zu erfassen, einen Kondensator mit einer Kapazität von 4 bis 100 pF, der konfiguriert ist, um die Spitzenspannung zu halten, und einen Programmierverstärker umfasst, der konfiguriert ist, um eine Verstärkung vor der Analog-Digital-Wandlung durchzuführen.

4. Magnetsensor nach einem der Ansprüche 1 bis 3, wobei die zwei leitenden Magnetdrähte (21, 22) aus einer amorphen CoFeSiB-Legierung mit einem Durchmesser im Bereich von etwa 5 $\mu$m bis etwa 20 $\mu$m gebildet sind und die Länge jedes der zwei leitenden Magnetdrähte im Bereich von etwa 0,07 mm bis etwa 1,0 mm liegt.

5. Magnetsensor nach einem der Ansprüche 1 bis 4, wobei die Anzahl der Windungen der Spule (3) im Bereich von 6 bis 180 liegt.

**6.** Magnetsensor nach einem der Ansprüche 1 bis 5, wobei der Abstand zwischen der Spule (3) und den zwei leitenden Magnetdrähten (21, 22) 3 μm oder weniger beträgt.

**Revendications**

**1.** Capteur micromagnétique, comprenant :

un élément de détection de champ magnétique (1) incluant un substrat (10) présentant une rainure (11), deux fils magnétiques conducteurs (21, 22) pour une détection de champ magnétique agencés adjacents et parallèles l'un à l'autre sur le substrat (10) et fixés dans la rainure (11), les extrémités inférieures des deux fils magnétiques (22) sont connectées par le biais d'une partie de connexion de fils (23), deux électrodes (24, 25) pour l'excitation des fils, une partie de connexion entre les fils magnétiques (21, 22) et les deux électrodes (24, 25) pour l'excitation des fils, une bobine ronde (3) enroulée autour des deux fils magnétiques (21, 22), deux électrodes (34, 35) pour une détection de tension de bobine, et une partie de connexion entre la bobine (3) et les deux électrodes (34, 35) pour une détection de tension de bobine ;
un circuit d'application de courant d'impulsion (51) configuré pour appliquer un courant d'impulsion aux fils magnétiques (21, 22) ;
un circuit de détection de tension de bobine (54) configuré pour détecter une tension de bobine qui s'est produite lorsque le courant d'impulsion est appliqué aux deux fils magnétiques (21, 22) ; et un circuit de conversion de tension (55 et 58) configuré pour convertir la tension de bobine en champ magnétique externe H, dans lequel les deux fils magnétiques conducteurs (21, 22) présentent un champ d'anisotropie magnétique de 20 G ou moins, avec une structure de domaine magnétique à deux phases d'un domaine magnétique de surface avec un agencement de spin circonférentiel et un domaine magnétique de noyau central avec un agencement de spin longitudinal, et
le courant d'impulsion appliqué aux fils magnétiques (21, 22) présente une fréquence d'impulsion de 0,2 GHz à 4,0 GHz et une intensité nécessaire à la génération d'un champ magnétique circonférentiel plus de 1,5 fois plus grand que le champ d'anisotropie sur une surface du fil, et
la bobine (3) présente un pas de bobine de 10 μm ou moins, **caractérisé en ce que**, dans l'élément de détection de champ magnétique (1), les deux fils magnétiques conducteurs (21, 22) sont agencés sur une partie inférieure (31) de la bobine (3), et sont fixés et couverts par une résine isolante,
une partie supérieure (32) de la bobine (3) est fournie sur la résine isolante,
la bobine ronde (3) est enroulée autour des deux fils magnétiques (21, 22), et
une paroi de séparation isolante (41) est agencée entre les deux fils magnétiques (21, 22).

**2.** Capteur magnétique selon la revendication 1, dans lequel le circuit de conversion de tension (55 et 58) est configuré pour convertir la tension de bobine en champ magnétique externe H en utilisant une équation :

$$Vs = Vo \cdot 2L \cdot \pi D \cdot p \cdot Nc \cdot f \cdot \sin(\pi H/2Hm) \ ..... \ (1)$$

où Vs est une tension de sortie de bobine et Vo est une constante de proportionnalité, et en tant que constante de facteur de commande, L est une longueur de fil, D est un diamètre de fil, p est une profondeur de pénétration d'un courant d'impulsion, Nc est un nombre d'enroulements d'une bobine, f est une fréquence d'impulsion, Hm est une intensité magnétique externe pour obtenir une tension de sortie de bobine maximale.

**3.** Capteur magnétique selon la revendication 1, dans lequel le circuit d'application de courant d'impulsion (51) comprend un circuit de génération d'impulsion configuré pour générer le courant d'impulsion, et le circuit de détection de tension de bobine (54) comprend un circuit d'entrée, un circuit tampon supportant les impulsions configuré pour entrer la tension de bobine, un circuit échantillonneur-bloqueur avec un commutateur électronique configuré pour détecter une tension de crête d'une forme d'onde de sortie de la tension de bobine, un condensateur avec une capacitance de 4 à 100 pF configuré pour maintenir la tension de crête, et un amplificateur programmeur configuré pour réaliser une amplification avant une conversion analogique-numérique.

**4.** Capteur magnétique selon les revendications 1 à 3,
dans lequel les deux fils magnétiques conducteurs (21, 22) sont constitués d'un alliage amorphe de CoFeSiB avec un diamètre dans la plage d'environ 5 $\mu$m à environ 20 $\mu$m et la longueur de chacun des deux fils magnétiques conducteurs est dans la plage d'environ 0,07 mm à environ 1,0 mm.

5. Capteur magnétique selon les revendications 1 à 4,
   dans lequel le nombre d'enroulements de la bobine (3) est dans la plage de 6 à 180.

6. Capteur magnétique selon les revendications 1 à 5,
   dans lequel l'espace entre la bobine (3) et les deux fils magnétiques conducteurs (21, 22) est de 3 $\mu$m ou moins.

Fig.1

Fig.2

Fig.3

Fig.4

Fig.5

detection
timing

coil voltage

t

Fig.6

Fig.7

Fig.8

Fig.9

Fig.10

Fig.11

Fig.12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160238673 A1

- JP 5839527 B